# EUROPÄISCHE PATENTSCHRIFT

(11) **EP 1 702 409 B1**
(45) Veröffentlichungstag und Bekanntmachung des Hinweises auf die Patenterteilung: **20.07.2011**
(21) Anmeldenummer: 04803828.5
(22) Anmeldetag: 14.12.2004
(51) Int. Cl.: H03K 17/95

(54) **SICHERHEITSSCHALTER ZUM ÜBERWACHEN EINER SCHLIESSPOSITION ZWEIER RELATIV ZUEINANDER BEWEGLICHER TEILE**
SAFETY SWITCH FOR MONITORING A CLOSING POSITION OF TWO PARTS WHICH CAN BE DISPLACED IN RELATION TO EACH OTHER
INTERRUPTEUR DE SECURITE SERVANT A SURVEILLER UNE POSITION DE FERMETURE DE DEUX PIECES MOBILES L'UNE PAR RAPPORT A L'AUTRE

(30) Priorität: 09.01.2004 DE 102004002438; 12.08.2004 DE 102004039975
(43) Veröffentlichungstag der Anmeldung: 20.09.2006
(73) Patentinhaber: Pilz GmbH & Co. KG, 73760 Ostfildern (DE)
(72) Erfinder: FLEINER, Jürgen, 72768 Reutlingen (DE); BARTH, Steffen, 70378 Stuttgart (DE); BLASCHKE, Dietrich, 73066 Uhingen (DE)
(74) Vertreter: Duhme, Torsten
(86) Internationale Anmeldenummer: PCT/EP2004/014200
(87) Internationale Veröffentlichungsnummer: WO 2005/067145

(56) Entgegenhaltungen:
- DE-A1- 3 045 848
- DE-C1- 10 222 186
- DE-U1- 7 927 546
- US-A- 4 757 213
- US-A1- 2002 039 023
- PATENT ABSTRACTS OF JAPAN Bd. 009, Nr. 047 (E-299), 27. Februar 1985 (1985-02-27) -& JP 59 186422 A (TATEISHI DENKI KK), 23. Oktober 1984 (1984-10-23)

## Beschreibung

Die vorliegende Erfindung betrifft einen Sicherheitsschalter zum Überwachen einer Schließposition zweier relativ zueinander beweglicher Teile, insbesondere zum Überwachen einer Schutztür an einer automatisierten Anlage, mit einem Betätiger und mit einem Sensor, die an jeweils einem der Teile fixierbar sind, wobei der Betätiger eine Betätigerantenne und der Sensor eine Sensorantenne besitzen, über die der Betätiger und der Sensor in der Schließposition der Teile transformatorisch, insbesondere transponderartig, gekoppelt sind.

Ein solcher Sicherheitsschalter ist aus DE 102 22 186 C1 bekannt.

Ein solcher Sicherheitsschalter wird von der Firma Euchner GmbH & Co. KG, 70771 Leinfelden-Echterdingen, Deutschland unter der Produktbezeichnung CES vertrieben.

Bei der Planung und Konstruktion von automatisiert arbeitenden Anlagen spielen Sicherheitsüberlegungen zum Schutz vor Unfällen eine zunehmend größere Rolle. Zur Absicherung der Anlagen werden verschiedene Schutzmaßnahmen eingesetzt, insbesondere Not-Aus-Schalter, Lichtschranken oder auch sog. Schutztüren, die den Zugang zu einem gefahrbringenden Teil der Anlage in Verbindung mit Schutzzäunen verhindern. Das Öffnen der Schutztür muss im Betrieb der Anlage fehlersicher erkannt werden, da die geöffnete Schutztür ein Sicherheitsrisiko darstellt. Die einschlägige europäische Norm EN 954-1 und vergleichbare und verwandte Vorschriften (bspw. die neue IEC EN 61508 oder die daraus abgeleitete prEN ISO 13849-1) legen die Anforderungen an die Schutzmaßnahmen fest. Die vorliegende Erfindung bezieht sich dementsprechend auf Sicherheitsschalter, die für den genannten Einsatzzweck vorgesehen und ausgebildet sind und daher zumindest der Kategorie 3 der EN 954-1 oder vergleichbare Sicherheitsanforderungen erfüllen.

Um die Schließposition einer Schutztür, allgemeiner zweier relativ zueinander beweglicher Teile, mit hinreichender Fehlersicherheit zu überwachen, sind im Stand der Technik verschiedene Sicherheitsschalter bekannt. Neben mechanischen Schaltern, die gleichzeitig auch eine Verriegelungsfunktion bieten können, gibt es verschiedene Arten von berührungslosen Sicherheitsschaltern. Diese bieten in verschmutzten Umgebungen Vorteile. Betätiger und Sensor sind bei einem bekannten Typ von berührungslosen Sicherheitsschaltern in der Schließposition magnetisch miteinander gekoppelt. Um Manipulationen zu verhindern, werden teilweise kodierte Magnetanordnungen verwendet.

Bei einem anderen Typ berührungsloser Sicherheitsschalter nutzt man eine individuell kodierte Kommunikation zwischen Sensor und Betätiger, die nur in der Schließstellung der beweglichen Teile möglich ist. Für derartige Sicherheitsschalter kommen insbesondere sog. Transponder (teilweise auch "Tag" genannt) zur Anwendung. Diese übertragen bei einer transformatorischen Kopplung mit dem Sensor eine individuelle Codierung an den Sensor. Zu dieser Art von Sicherheitsschaltern gehört der eingangs genannte Schalter der Firma Euchner.

Ein weiterer gattungsgemäßer Sicherheitsschalter wird von der Firma K. A. Schmersal GmbH, 42232 Wuppertal, Deutschland unter der Bezeichnung BZ 16 angeboten. Dieser bekannte Sicherheitsschalter besitzt den Nachteil, dass für jede Anfahrrichtung, d.h. Annäherungsrichtung von Betätiger zum Sensor, eine eigene Schaltervariante verwendet werden muss. Wird beispielsweise für eine Anwendung ein Sicherheitsschalter benötigt, bei dem der Betätiger nicht von vorne, sondern von oben an den Sensor herangeführt werden soll, ist eine andere Variante des bekannten Sicherheitsschalters erforderlich. Dies erschwert in Einzelfällen nicht nur die Montage des Sicherheitsschalters, sondern führt auch zu erhöhten Lagerhaltungskosten, und zwar sowohl auf Seiten des Herstellers als auch auf Anwenderseite, da es für einen störungsfreien Produktionsablauf wünschenswert ist, immer eine gewisse Anzahl an Ersatzteilen wichtiger Komponenten zur Verfügung zu haben.

Bei dem eingangs genannten Sicherheitsschalter CES von Euchner ist es zur Vermeidung dieses Problems möglich, den "Sensorkopf", d.h. denjenigen Teil des Sensors, der die Sensorantenne beinhaltet, in verschiedenen Orientierungen an dem Sicherheitsschalter zu montieren. Durch Verkippen des Sensorkopfes können daher unterschiedliche Anfahrrichtungen realisiert werden. Diese Lösung ermöglicht zwar eine reduzierte Lagerhaltung, sie ist jedoch umständlich bei der Montage.

Aus EP 0 968 567 B1 ist ferner ein grundsätzlicher Aufbau eines transponderbasierten Sicherheitsschalters für den vorliegenden Anwendungszweck bekannt. Das hier beschriebene Problem wird jedoch nicht betrachtet.

Aus der eingangs genannten DE 102 22 186 C1 ist ein Sicherheitsschalter bekannt. Dieser Sicherheitsschalter wirkt mit einem Betätiger zusammen, wobei die beiden Bauelemente mittels elektromagnetischer Signale kommunizieren. Der Sicherheitsschalter weist eine Auswerteschaltung auf, die einen Integrator besitzt, um die mittels der elektromagnetischen Signale induzierte elektrische Energiemenge über eine Zeitspanne zu erfassen. Über- oder unterschreitet die Energiemenge einen vorgeschriebenen Schwellwert, so wird ein Schaltsignal bereitgestellt.

Aus DE 30 45 848 geht ein berührungslos steuerbarer elektronischer Schalter hervor, der mehrere voneinander getrennte Antennenschaltungen aufweist. Die Antennenschaltungen weisen jeweils eine Antenne auf, wobei die unterschiedlichen Antennen in unterschiedliche Raumrichtungen ausgerichtet sind. Es wird ermöglicht, dass der Schalter aus Richtung der unterschiedlichen Raumrichtungen angesprochen werden kann. Die einzelnen Antennenschaltungen sind innerhalb des Schalters durch eine Logikschaltung derart miteinander verbunden, dass er bei Ansprechen aus einer oder mehreren der Raumrichtungen schaltet.

Vor diesem Hintergrund ist es eine Aufgabe der vorliegenden Erfindung, einen gattungsgemäßen Sicherheitsschalter derart weiterzubilden, dass bei gleich hoher Sicherheit eine einfachere Montage und eine reduzierte Lagerhaltung möglich ist.

Diese Aufgabe wird gemäß einem Aspekt der vorliegenden Erfindung dadurch gelöst, dass die Sensorantenne eine magnetische Richtcharakteristik besitzt, die ausgehend von der Sensorantenne in zumindest zwei zueinander senkrechten Raumrichtungen eine transformatorische Kopplung mit dem Betätiger ermöglicht, wobei die Richtcharakteristik eine stärkere erste und eine schwächere zweite Vorzugsrichtung für die transformatorische Kopplung aufweist und wobei die Sensorantenne in einem Sensor gehäuse mit Gehäusewänden angeordnet ist, wobei ein Abstand zwischen Sensorantenne und Gehäusewand in der ersten Vorzugsrichtung größer ist als in der zweiten Vorzugsrichtung.

Unterschiedliche Anfahrrichtungen des Betätigers werden hiernach also durch eine neue Richtcharakteristik der Sensorantenne ermöglicht, wobei diese Richtcharakteristik im konkreten Fall auch noch von der jeweiligen Orientierung des Betätigers zur Sensorantenne abhängt (wird im folgenden noch näher erläutert). Es versteht sich in diesem Zusammenhang, dass die Richtcharakteristik der Sensorantenne in den zumindest zwei zueinander senkrechten Raumrichtungen so ausgebildet ist, dass die zueinander senkrechten Anfahrrichtungen jeweils einen definierten Schaltabstand gewährleisten. Der Schaltabstand ist dabei diejenige (maximale) Entfernung zwischen Sensor und Betätiger, ab der der Sicherheitsschalter die Schließposition der zueinander beweglichen Teile erkennt.

Die erfindungsgemäße Lösung verwendet damit erstmals für den hier interessierenden Anwendungsbereich eine Sensorantenne, die mehr als nur eine definiert nutzbare Vorzugsrichtung besitzt. Im Gegensatz dazu kommen bei allen bekannten gattungsgemäßen Sicherheitsschaltern Sensorantennen zum Einsatz, die eine Richtcharakteristik mit nur einer nutzbaren Vorzugsrichtung haben. Dementsprechend ist es bei den gattungsgemäßen Sicherheitsschaltern erforderlich, entweder unterschiedliche Schaltervarianten bereitzustellen oder den Sensorkopf in die gewünschte Richtung zu verdrehen. Im Gegensatz dazu nutzt die vorliegende Lösung eine im einfachsten Fall ungerichtete Sensorantenne, die grundsätzlich aus beliebigen Raumrichtungen angefahren werden kann.

Die Erfindung basiert u.a. auf der Erkenntnis, dass eine Richtcharakteristik mit nur einer Vorzugsrichtung zur Gewährleistung der erforderlichen Sicherheit nicht erforderlich ist. Theoretisch eröffnen die verschiedenen Anfahrrichtungen zwar die Möglichkeit von Manipulationen. Diese lassen sich jedoch auf andere Weise, insbesondere bei Verwendung individuell kodierter Transponder, zuverlässig abfangen. Auch für die Gewährleistung eines definierten Schaltabstandes ist eine Sensorantenne mit nur einer Vorzugsrichtung nicht erforderlich. Wie sich bei praktischen Versuchen der Anmelderin gezeigt hat, können definierte Schaltabstände auch aus mehreren Anfahrrichtungen mit der erfindungsgemäßen Lösung realisiert werden.

Der neue Sicherheitsschalter erlaubt einen einfachen Wechsel der Einbaulage des Sensors, ohne dass dazu mechanische Teile ummontiert oder geändert werden müssen. Dementsprechend kann der neue Sicherheitsschalter flexibel in verschiedenen Anfahrrichtungen eingesetzt werden. Die Lagerhaltungskosten sind ohne zusätzlichen Montageaufwand reduziert. Die eingangs genannte Aufgabe ist somit vollständig gelöst.

Darüber hinaus besitzt die neue Lösung den weiteren Vorteil, dass sich die Gehäusekonstruktion für den Sicherheitsschalter vereinfacht, insbesondere wenn schmutz- und/oder spritzwassergeschützte Gehäuse gewünscht sind.

Weiter ist die Sensorantenne in der ersten, stärkeren Vorzugsrichtung mit größerem Abstand zu der Gehäusewand angeordnet als in der zweiten, schwächeren Vorzugsrichtung. Auf Grund des größeren Abstandes und der mit der Entfernung abnehmenden Feldstärke lassen sich unterschiedliche Schaltabstände in den verschiedenen Anfahrrichtungen einfach und elegant ausgleichen. Der neue Sicherheitsschalter besitzt in dieser Ausgestaltung daher ein gleichmäßigeres Ansprechverhalten in den verschiedenen Anfahrrichtungen.

In einer bevorzugten Ausgestaltung besitzt die Sensorantenne eine im Wesentlichen rundstrahlerartige Richtcharakteristik.

In dieser Ausgestaltung ist die Sensorantenne somit nicht nur auf zwei Anfahrrichtungen festgelegt, sondern sie ermöglicht das Anfahren des Betätigers aus zahlreichen Raumrichtungen. Die rundstrahlerartige Richtcharakteristik kann dabei auf eine Ebene beschränkt sein, also ein Anfahren von vorne, rechts, links und eventuell von hinten ermöglichen. In einer bevorzugten Ausgestaltung ist die rundstrahlerartige Richtcharakteristik aber räumlich, d.h. die neue Sensorantenne ermöglicht zudem auch ein Anfahren von oben oder unten. Im Idealfall besitzt die neue Sensorantenne somit eine kugelartige Richtcharakteristik, wobei den einschlägigen Fachleuten bekannt ist, dass eine exakte Kugelform (ohne Einbrüche oder "Dellen") in der Praxis kaum zu realisieren ist. Eine rundstrahlerartige Richtcharakteristik im Sinne der vorliegenden Erfindung ist daher auch dann gegeben, wenn ein Anfahren des Betätigers an den Sensor aus zahlreichen unterschiedlichen Raumrichtungen möglich ist. Diese Ausgestaltung schließt ferner nicht aus, dass einzelne Raumrichtungen aus anderen Gründen, beispielsweise wegen mechanischer Behinderungen durch Zuleitungskabel, ausgeschlossen sind.

Die bevorzugte Ausgestaltung führt zu einer besonders großen Flexibilität des neuen Sicherheitsschalters in Bezug auf die Montagelage. Darüber hinaus besitzt diese Ausgestaltung den Vorteil, dass die Sensorantenne mit größeren Toleranzen hergestellt und in dem Sicherheitsschalter montiert werden kann, was die Herstellungskosten reduziert.

In einer weiteren Ausgestaltung beinhaltet die Sensorantenne eine Vielzahl von Teilantennen mit unterschiedlich ausgerichteten Richtcharakteristiken.

In einem Ausführungsbeispiel beinhaltet die Sensorantenne beispielsweise zwei senkrecht zueinander angeordnete Teilantennen, die für jeweils eine oder zwei Anfahrrichtungen "verantwortlich" sind. Durch Umschalten zwischen den Antennen oder auch durch Überlagerung der Richtcharakteristiken bei gleichzeitigem Betrieb kann eine rundstrahlerartige Richtcharakteristik mit großer Gleichmäßigkeit realisiert werden. Daher vereinfacht diese Ausgestaltung die Realisierung gleicher Schaltabstände in unterschiedlichen Anfahrrichtungen.

In einer weiteren Ausgestaltung beinhaltet die Sensorantenne eine Luftspule.

Die Verwendung von Spulen als Sensorantennen ist bei gattungsgemäßen Sicherheitsschaltern durchaus üblich. In allen bislang bekannten Fällen werden die Spulen jedoch in einem Ferrittopf eingesetzt, um die übliche "einseitige" Richtcharakteristik zu erreichen. Bei einer Luftspule handelt es sich demgegenüber hier um eine Leiterschleife, die ohne Ferrittopf (ggf. jedoch mit einem Ferritkern zur Erhöhung der Induktivität) arbeitet. Auf Grund der reduzierten Teilevielfalt dieser Ausgestaltung sind die Materialkosten und der Montageaufwand bei der Herstellung geringer. Darüber hinaus bietet eine Luftspule von sich aus bereits eine Feldverteilung, die mehrere zueinander senkrechte Anfahrrichtungen ermöglicht.

In einer weiteren Ausgestaltung beinhaltet die Sensorantenne eine Spule, die auf einem Bauteilträger des Sensors flach angeordnet ist. Besonders bevorzugt ist es, wenn die Spule dabei als Leiterbahn auf dem Bauteilträger ausgebildet ist.

Diese Ausgestaltung ermöglicht eine besonders kleine und flache Bauform des neuen Sicherheitsschalters. Überraschenderweise hat sich gezeigt, dass diese Verkleinerung der Baugröße ohne nennenswerte Einschränkungen in Bezug auf die Reichweite (Schaltabstand) des neuen Sicherheitsschalters möglicht ist. Im Gegenteil, die neue flache Bauform ermöglicht eine dichtere Montage des neuen Sicherheitsschalters an Türholmen o.ä., so dass der effiektiv nutzbare Rechweitenbereich sogar größer wird. Darüber hinaus ermöglicht diese Ausgestaltung eine Kostenreduzierung, da Gehäuseteile kleiner ausfallen können. Besonders kostengünstig ist es, wenn man die Spule als Leiterbahn auf dem Bauteilträger realisiert, weil damit eine besonders rationelle Herstellung möglich wird.

In einer weiteren Ausgestaltung ist die Sendeantenne senkrecht zu der ersten Vorzugsrichtung in gleichem Abstand zu zumindest zwei Gehäusewänden angeordnet.

Diese Ausgestaltung ist besonders vorteilhaft, wenn als Sendeantenne eine Luftspule verwendet wird, da deren Feldverteilung senkrecht zur Spulenlängsachse weitgehend rotationssymmetrisch ist. Durch die gleichen Abstände zu den Gehäusewänden senkrecht zu der ersten Vorzugsrichtung wird das Ansprechverhalten des neuen Sicherheitsschalters noch gleichmäßiger.

In einer weiteren Ausgestaltung besitzt der neue Sicherheitsschalter ein Sensorgehäuse mit einer Montageseite, wobei zwischen Sensorantenne und Montageseite eine Feldisolierung angeordnet ist. Als Feldisolierung kommt insbesondere eine elektrisch und/oder magnetisch leitfähige Platte, beispielsweise also eine Kupfer-, Aluminium-, Eisen-, Weicheisen- und/oder Ferritplatte zur Anwendung.

Diese Ausgestaltung beseitigt einen möglichen Nachteil des neuen Sicherheitsschalters, nämlich die mögliche Beeinflussung der Richtcharakteristik durch Materialien am Montageort. Typischerweise werden gattungsgemäße Sicherheitsschalter mit einer Montageseite an einem der relativ zueinander beweglichen Teile, beispielsweise also an einem Türrahmen, angeschraubt. Wenn dieser Türrahmen aus Metall besteht, kann die Richtcharakteristik der Sensorantenne beeinflusst werden. Hierdurch können die Schaltabstände variieren. In der bevorzugten Ausgestaltung wird dieser Einfluss reduziert und/oder in einer determinierten Weise vorweggenommen. Die Montage des Sensors auf einer Metallplatte hat damit keinen oder zumindest einen deutlich geringeren Einfluss auf die Sensorantenne. Die Betriebsparameter des neuen Sicherheitsschalters können mit geringeren Toleranzen eingehalten werden.

In einer weiteren Ausgestaltung beträgt ein Abstand zwischen der Sensorantenne und der Montageseite etwa 5 mm oder mehr.

Auch diese Ausgestaltung trägt dazu bei, den Einfluss einer metallischen Montagefläche auf den Sicherheitsschalter zu minimieren. Der angegebene Abstand von etwa 5 mm zwischen der Sensorantenne und der Montageseite, gemessen als lichter Abstand zwischen der Außenseite der Antenne und der für die Montage vorgesehenen Gehäuseaußenseite, hat sich bei praktischen Versuchen als ausreichend für einen zuverlässigen Betrieb erwiesen. Größere Abstände verringern den Einfluss des Montageortes weiter. Bei wesentlich kleineren Abständen besteht ein für die sicherheitstechnische Anwendung zu großer Einfluss des Montageortes auf die Schaltabstände.

In einer weiteren Ausgestaltung besitzt die Betätigerantenne bei der transformatorischen Kopplung in einer ersten der zumindest zwei senkrechten Raumrichtungen eine erste Orientierung und bei der transformatorischen Kopplung in einer zweiten der zumindest zwei senkrechten Raumrichtungen eine zweite Orientierung auf, wobei die erste und die zweite Orientierung um etwa 90° verdreht zueinander sind.

Die bedeutet mit anderen Worten, dass der Betätiger (mit seiner Betätigerantenne) in Abhängigkeit von der gewünschten Anfahrrichtung gedreht wird. Alternativ hierzu ist es grundsätzlich auch möglich, die Orientierung des Betätigers für jede Anfahrrichtung gleich zu belassen. Die bevorzugte Ausgestaltung besitzt demgegenüber mechanische Vorteile. Um einen definierten Schaltabstand zu gewährleisten, ist es nämlich wünschenswert, relativ große Spulendurchmesser von bspw. 28 mm auf Seiten der Betätigerantenne zu verwenden. Andererseits kann die Betätigerantenne in der Antennenachse relativ flach sein, so dass der Betätiger in der Antennenachse viel kürzer ist als seitlich dazu. Die bevorzugte Ausgestaltung besitzt den Vorteil, dass der Betätiger unabhängig von der Anfahrrichtung jeweils gleich nah an den Sensor herangefahren werden kann. Dies erleichtert die Montage und vereinfacht die Bereitstellung definierter Schaltabstände.

Ausführungsbeispiele der Erfindung sind in der Zeichnung dargestellt und werden in der nachfolgenden Beschreibung näher erläutert. Es zeigen:
- Fig. 1: eine schematische Darstellung einer automatisierten Anlage mit dem neuen Sicherheitsschalter,
- Fig. 2: eine vereinfachte Darstellung eines Ausführungsbei- spiels des neuen Sicherheitsschalters,
- Fig. 3: den Sicherheitsschalter aus Fig. 2 mit seiner magneti- schen Richtcharakteristik in vereinfachter Darstellung,
- Fig. 4: ein Prinzipschaltbild für ein weiteres Ausführungsbei- spiel des neuen Sicherheitsschalters,
- Fig. 5: eine vereinfachte Darstellung eines weiteren Ausfüh- rungsbeispiels des neuen Sicherheitsschalters, und
- Fig. 6: den Sicherheitsschalter aus Fig. 5 in einer zweiten Betriebsposition.

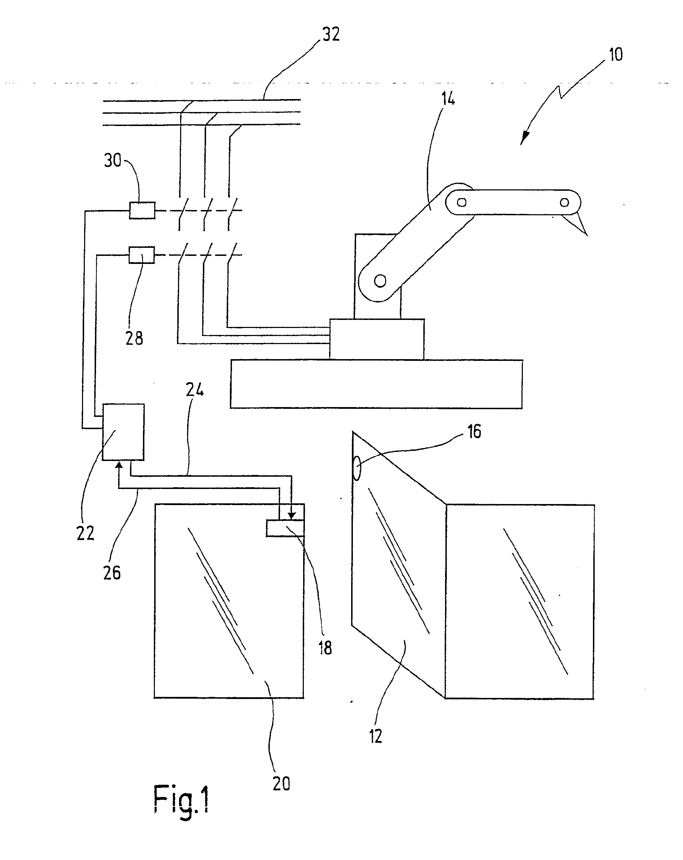

In Fig. 1 ist eine automatisierte Anlage mit dem neuen Sicherheitsschalters in ihrer Gesamtheit mit der Bezugsziffer 10 bezeichnet. Der Sicherheitsschalter dient hier zum Überwachen der Schließposition einer Schutztür 12, die ihrerseits zum Absichern der Anlage vorgesehen ist. Beispielhaft ist die Anlage hier als Roboter 14 dargestellt. Der Einsatzbereich des neuen Sicherheitsschalters ist jedoch nicht auf dieses konkrete Beispiel beschränkt. Generell kann der neue Sicherheitsschalter zum sicheren Überwachen jeglicher (Schließ-)Positionen von zwei relativ zueinander beweglichen Teilen verwendet werden. Dies beinhaltet beispielsweise auch die Überwachung einer Kolbenposition relativ zu einem Kolbenzylinder oder einem anderen Kolben, wobei der Begriff "Schließposition" in diesem Fall bedeutet, dass der Kolben sich im Bereich des anderen Gegenstandes befindet.

Der Sicherheitsschalter beinhaltet einen Betätiger 16 und einen Sensor 18. Der Betätiger 16 ist hier an der Schutztür 12 angebracht. Der Sensor 18 ist an einer Wand 20 (oder einem hier nicht dargestellten Rahmen für die Schutztür 12) angebracht. Im geschlossenen Zustand der Schutztür 12 (hier nicht dargestellt) befindet sich der Betätiger 16 in räumlicher Nähe zum Sensor 18, was in der nachfolgend näher erläuterten Weise zu einer transponderartigen Kopplung zwischen Betätiger 16 und Sensor 18 führt. Beim Öffnen der Schutztür 12 wird der Betätiger 16 vom Sensor 18 entfernt, was zur Folge hat, dass die transponderartige Kopplung "abreißt". Der Sensor 18 erzeugt daraufhin ein Schaltsignal, das zum Abschalten des Roboters 14 führt.

Der Sensor 18 ist hier über zwei Leitungen mit einem Sicherheitsschaltgerät 22 verbunden. Eine erste Leitung 24 führt vom Sicherheitsschaltgerät 22 zum Sensor 18. Über diese Leitung kann das Sicherheitsschaltgerät 22 Testsignale an den Sensor 18 übertragen, um dessen Funktionssicherheit zu überprüfen. Über die zweite Leitung 26 empfängt das Sicherheitsschaltgerät 22 ein vom Sensor 18 erzeugtes Schaltsignal, das den Schließzustand der Schutztür 12 signalisiert. Eine bevorzugte Art der Überwachung des Sensors durch das Sicherheitsschaltgerät 22 ist in der WO 2005/013488 A2, veröffentlicht am 10.02. 2005, beschrieben. Alternativ hierzu kann der Sensor 18 jedoch auch in anderer Weise fehlersicher im Sinne der einschlägigen Vorschriften (zumindest Kategorie 3 der EN 954-1 oder vergleichbare Sicherheitsanforderungen) aufgebaut sein. Eine Realisierung mit einer zweikanaligen Auswertestruktur ist beispielsweise in der eingangs genannten EP 0 968 567 B1 beschrieben.

Ausgangsseitig steuert das Sicherheitsschaltgerät 22 hier zwei Schütze 28, 30, deren Arbeitskontakte in an sich bekannter Weise in einer Stromzuführung 32 des Roboters 14 angeordnet sind. Über die Schütze 28, 30 unterbricht das Sicherheitsschaltgerät 22 die Stromzufuhr für den Roboter 14, wenn mit Hilfe der Betätiger-Sensor-Kombination 16, 18 ein Öffnen der Schutztür 12 festgestellt wird, oder wenn im Rahmen der erwähnten Fehlerüberwachung ein undefinierter und damit sicherheitskritischer Zustand erkannt wird.

Bei dem Sicherheitsschaltgerät 22 handelt es sich hier vorzugsweise um ein Gerät, das die Kategorie 4 der europäischen Norm EN 954-1 oder eine vergleichbare Sicherheitsnorm erfüllt. Beispielsweise handelt es sich hier um ein Sicherheitsschaltgerät vom Typ PNOZ®elog der Anmelderin der vorliegenden Erfindung. Alternativ hierzu könnte der Sensor 18 jedoch auch mit einer programmierbaren Sicherheitssteuerung verbunden sein, wie sie von der vorliegenden Anmelderin unter der Bezeichnung PSS® vertrieben wird.

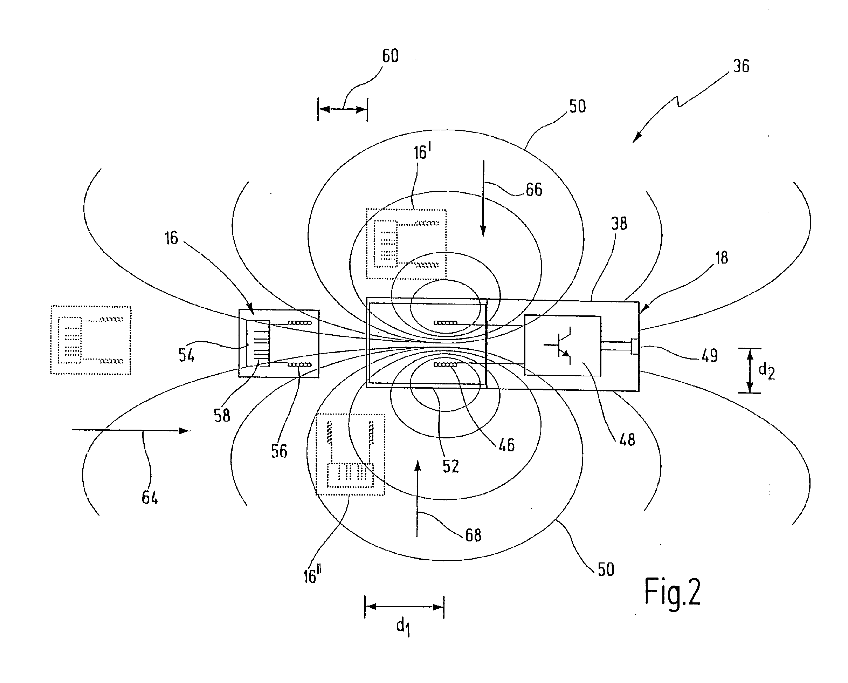

In Fig. 2 ist ein Ausführungsbeispiel des neuen Sicherheitsschalters in seiner Gesamtheit mit der Bezugsziffer 36 bezeichnet. Im Übrigen bezeichnen gleiche Bezugszeichen dieselben Elemente wie zuvor.

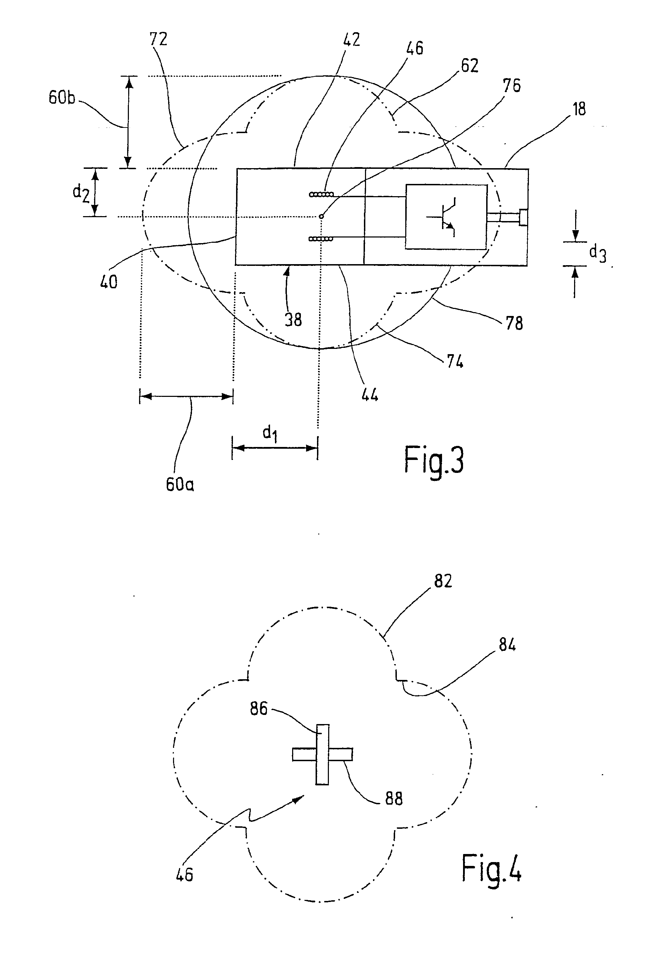

Der Sensor 18 des Sicherheitsschalters 36 besitzt ein Sensorgehäuse 38 mit Gehäusewänden 40, 42, 44 (vgl. Fig. 3). Das Sensorgehäuse ist hier zweigeteilt. In einem ersten Teil ist die Sensorantenne 46 angeordnet, die hier als Luftspule ausgebildet ist. Schematisch dargestellt ist die Luftspule 46 hier in einem Schnitt parallel zur Spulenlängsachse.

In dem zweiten Teil des Sensorgehäuses 38 ist eine elektronische Schaltung 48 angeordnet, mit der die Sensorantenne 46 verbunden ist. Die Schaltung 48 beinhaltet insbesondere einen sog. Tag-Reader, d.h. einen Schaltkreis, der Transpondersignale des Betätigers 16 dekodiert und die individuelle Kennung als Datenwert bereitstellt. Ferner ist eine fehlersichere Auswerteeinheit enthalten, die abhängig von den Signalen des Betätigers 16 ein Schaltsignal für das Sicherheitsschaltgerät 22 erzeugt. Zu diesem Zweck ist die Schaltung 48 über einen Anschluss 49 mit dem Sicherheitsschaltgerät 22 verbindbar.

Die hier zweiteilige Ausbildung des Sensorgehäuses 38 ist für die praktische Realisierung der vorliegenden Erfindung nicht zwingend notwendig, sie besitzt jedoch Vorteile, da sie eine gleichmäßigere Feldausbreitung der Sensorantenne 46 sowie eine bessere Entkopplung der Schaltung 48 ermöglicht.

Mit der Bezugsziffer 50 sind die magnetischen Feldlinien bezeichnet, die das magnetische Feld um die Luftspule 46 herum charakterisieren. Die Feldlinien 50 bilden sich weitgehend rotationssymmetrisch zur Längsachse der Luftspule 46 aus. Etwaige Störungen des hier gezeigten idealtypischen Verlaufs, beispielsweise durch die Schaltung 48 oder Metallteile in der Umgebung des Sensors, sind der Übersichtlichkeit halber nicht dargestellt.

Eine Ausbildung des Sensors 18 beinhaltet, dass unterhalb der Sensorantenne 46 (in der Darstellung in Fig. 2), d.h. zwischen der Sensorantenne 46 und einer zur Montage des Sensors 18 vorgesehenen Gehäusewand, eine Feldisolierung 52 angeordnet ist. Die Feldisolierung kann auch die entsprechende Gehäusewand selbst sein. In einem Ausführungsbeispiel ist die Feldisolierung eine Eisenplatte. In anderen Ausführungsbeispielen handelt es sich um eine Platte aus Weicheisen, Ferrit, Kupfer, Aluminium oder dgl. Es versteht sich, dass die magnetischen Feldlinien 50 im Bereich unterhalb des Sensors 18 dann einen anderen Verlauf annehmen und insofern keine vollständige Rotationssymmetrie mehr vorliegt. In einfacheren Ausführungsbeispielen kann die Feldisolierung 52 entfallen. Bevorzugt ist die Sensorantenne 46 dann in einem Abstand von etwa 5 mm oder mehr zu der Gehäuseaußenseite angeordnet, mit der der Sensor 18 montiert wird. Dieser Abstand ist in Fig. 3 (dort allerdings mit Bezug auf die seitliche Gehäusewand 44) mit d₃ bezeichnet.

Der Betätiger 16 besitzt in an sich bekannter Weise eine integrierte Schaltung 54, die mit einer Betätigerantenne 56 verbunden ist. Die Betätigerantenne 56 ist hier ebenfalls als Luftspule dargestellt, kann im Einzelfall jedoch auch eine andere Bauform besitzen. In der Schaltung 54 ist eine Codierung abgespeichert, die hier durch symbolische Striche 58 dargestellt ist. Die Codierung 58 ist dem Betätiger 16 individuell zugeordnet, so dass der Sensor 18 den Betätiger 16 an Hand der Codierung 58 identifizieren kann.

Typisch für den hier gezeigten Betätiger 16 ist, dass er keine eigene Energieversorgung besitzt. Die Energie zur Versorgung der integrierten Schaltung 54 erhält er vielmehr von dem Sensor 18, wenn die beiden Antennen 46, 56 eine hinreichend starke transformatorische Kopplung aufweisen. Eine solche liegt dann vor, wenn die Feldlinien 50 des von der Sensorantenne 46 erzeugten Magnetfeldes mit einer orthogonalen Komponente durch den Flächenquerschnitt der Betätigerantenne 56 hindurchtreten, wie das für den Betätiger 16 in Fig. 2 dargestellt ist. Die Schaltung 54 wird dann angeregt und moduliert das vorhandene Feld mit der internen Codierung 58, was von der Schaltung 48 im Sensor 18 detektiert und ausgewertet werden kann.

Da das magnetische Feld 50 der Sensorantenne 46 mit zunehmender Entfernung schwächer wird, hängt die transformatorische Kopplung von der Entfernung zwischen Betätiger 16 und Sensor 18 ab. Unterschreitet die Entfernung einen definierten Schaltabstand, kann der Sensor 18 den Betätiger 16 auslesen. Außerhalb der entsprechenden Entfernung ist eine Kommunikation zwischen den beiden nicht möglich. Der entsprechende Schaltabstand ist in Fig. 2 symbolisch bei der Bezugsziffer 60 angedeutet.

Die Sensorantenne 46 besitzt in diesem Ausführungsbeispiel eine weitgehend rundstrahlerartige Richtcharakteristik 62 (vgl. Fig. 3). Daher ist eine transformatorische Kopplung zwischen Betätiger 16 und Sensor 18 hier nicht nur möglich, wenn der Betätiger 16 von vorne, d.h. in Richtung des Pfeils 64, an den Sensor 18 angenähert wird. Vielmehr ist eine Kopplung auch bei einer Annäherung aus den Anfahrrichtungen seitlich zum Betätiger 18 (Pfeile 66, 68) möglich. Ursache hierfür ist die in Fig. 2 angedeutete Feldlinienverteilung 50. Wie dargestellt, treten senkrechte Feldlinienkomponenten auch durch den Flächenquerschnitt der Betätigerantenne 56, wenn sich der Betätiger 16 an den mit 16' bzw. 16" gekennzeichneten Positionen befindet. Der Sicherheitsschalter 36 ermöglicht damit zueinander senkrechte Anfahrrichtungen zwischen Betätiger 16 und Sensor 18.

Für die seitliche Anfahrrichtung ist in der praktischen Realisierung derzeit die Orientierung des Betätigers bevorzugt, die bei der Bezugsziffer 16" gezeigt ist, d.h. der Betätiger ist hier gegenüber der Anfahrrichtung 64 um 90° verdreht. Der Betätiger kann in diesem Fall unabhängig von der Anfahrrichtung gleich dicht an den Sensor herangefahren werden. Im anderen Fall (Orientierung gemäß 16') kann ein großer Spulendurchmesser der Betätigerantenne 56 eine dichte Annäherung mechanisch behindern. Grundsätzlich ist jedoch auch die Orientierung 16' möglich.

In Fig. 3 ist die Richtcharakteristik 62 der Sensorantenne 46 vereinfacht dargestellt. Dabei handelt es sich hier in an sich bekannter Weise um den räumlichen Verlauf gleicher Feldstärke für eine magnetische Feldkomponente, die hier parallel zur Anfahrrichtung 64 (Fig. 2) des Betätigers 16 liegt. Diese Feldlinienkomponente ist maßgeblich, wenn der Betätiger 16 in der Orientierung an den Sensor 18 angenähert wird, die den Positionen bei den Bezugsziffern 16 bzw. 16' in Fig. 2 entspricht. Wird der Betätiger hingegen in einer dazu um 90° verdrehten Orientierung (Bezugsziffer 16") an den Sensor 18 angenähert, sind die dazu senkrechten Feldkomponenten maßgeblich, was zu einem anderen Aussehen der Richtcharakteristik führen würde (konkret in der Art eines vierblätterigen Kleeblattes, dessen Blätter etwa diagonal zur Längsachse der Spule 46 liegen). Daher können sich abhängig von der Orientierung des Betätigers 16, 16 " unterschiedliche Verläufe der Richtcharakteristik und damit unterschiedliche Schaltabstände ergeben. Das Grundprinzip der "ungerichteten" Richtcharakteristik bleibt davon jedoch unberührt.

Wie in Fig. 3 dargestellt, besitzt die Richtcharakteristik 62 hier eine erste Vorzugsrichtung 72 in Richtung der Längsachse der Luftspule 46 sowie eine zweite Vorzugsrichtung 74 quer dazu. Die beiden Vorzugsrichtungen 72, 74 sind bei einer Luftspule grundsätzlich symmetrisch zu einer Ebene durch den gedachten Mittelpunkt 76 der Luftspule 46. Daher gibt es hier jeweils zwei gleichstarke Vorzugsrichtung, die entgegengesetzt zueinander liegen. Im Vergleich zueinander sind die beiden Vorzugsrichtungen 72, 74 jedoch unterschiedlich stark ausgeprägt, wie sich an Hand des zur Veranschaulichung eingezeichneten Kreises 78 erkennen lässt. Konkret ist die erste Vorzugsrichtung 72 (parallel zur Längsachse der Luftspule 46) stärker ausgeprägt als die zweite Vorzugsrichtung 74. Mit anderen Worten liegt in der ersten Vorzugsrichtung 72 bei gleicher Entfernung zur Luftspule 46 eine höhere Feldstärke vor und der Verlauf gleicher Feldstärke reicht in der ersten Vorzugsrichtung 72 bis zu einer größeren Entfernung. Daher führt die Luftspule 46 an sich zu unterschiedlichen Schaltabständen zwischen Betätiger 16 und Sensor 18 in Abhängigkeit von der Anfahrrichtung. Zum Ausgleich dessen ist die Luftspule 46 hier mit unterschiedlichen Abständen d₁ und d₂ zu den Gehäusewänden 40 bzw. 42, 44 angeordnet. Konkret besitzt die Luftspule 46 zu den beiden seitlichen Gehäusewänden 42, 44 den gleichen, geringeren Abstand d₂, während sie zu der vorderen Gehäusewand 40 einen größeren Abstand d₁ aufweist. Hierdurch werden die Schaltabstände beim Anfahren in den beiden Vorzugsrichtungen 72, 74 aneinander angeglichen, wie in Fig. 3 an Hand der Schaltabstände 60a, 60b angedeutet ist.

Fig. 4 zeigt in einer stark vereinfachten Darstellung eine weitere Richtcharakteristik 82 für eine Sensorantenne. Die Richtcharakteristik 82 ist in den zueinander senkrechten Raumrichtungen annähernd gleich ausgeprägt, wobei den einschlägigen Fachleuten bekannt ist, dass sie trotzdem an einigen Stellen Einbuchtungen 84 aufweisen kann. Erreicht wird diese hier annähernd gleichmäßige Ausbildung der Richtcharakteristik durch die Verwendung mehrerer Teilantennen 86, 88. In dem gezeigten Ausführungsbeispiel sind beispielsweise zwei Luftspulen 86, 88 kreuzweise zueinander angeordnet und so miteinander verschaltet, dass sich ihre individuellen Richtcharakteristiken zu der gleichmäßigeren Gesamtcharakteristik 82 überlagern. Es ist leicht einzusehen, dass sich mit der Richtcharakteristik 82 die Schaltabstände in den unterschiedlichen Anfahrrichtungen 64, 66 noch weiter angleichen lassen.

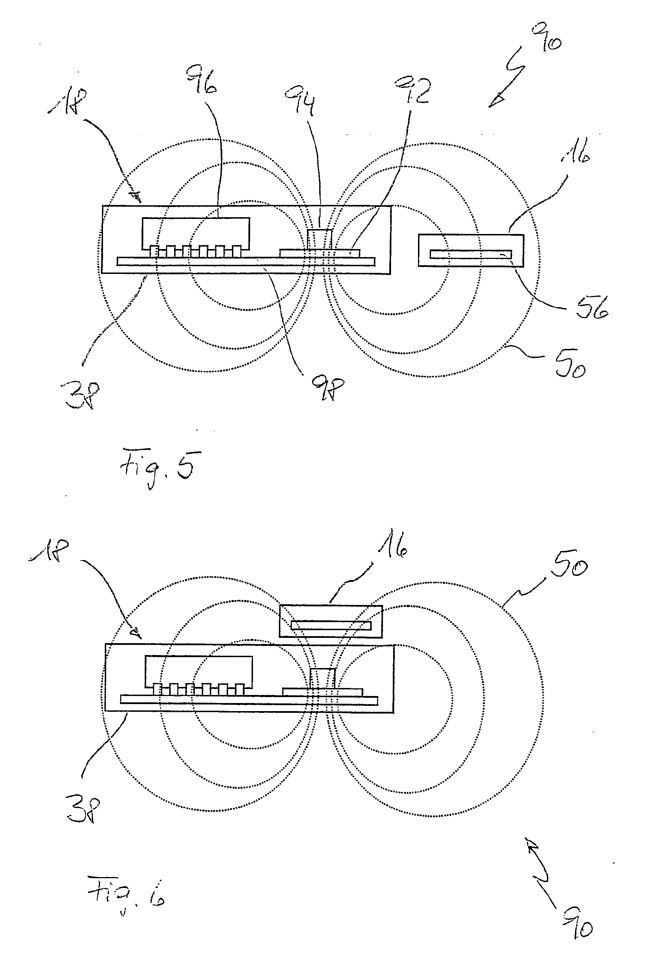

Fig. 5 und 6 zeigen ein weiteres Ausführungsbeispiel des neuen Sicherheitsschalters, der hier in seiner Gesamtheit mit der Bezugsziffer 90 bezeichnet ist. Im übrigen bezeichnen gleiche Bezugszeichen dieselben Elemente wie zuvor.

Der Sensor 18 des Sicherheitsschalters 90 besitzt eine Sensorantenne 92 in Form einer flach liegenden Spule. Dabei kann es sich um eine Spule aus gewickeltem Draht oder dergleichen handeln. Im bevorzugten Ausführungsbeispiel ist die Spule 92 jedoch als gedruckte oder geätzte Leiterbahn auf einem Bauteilträger ausgebildet. Unabhängig davon besitzt die Spule 92 hier einen im Zentrum angeordneten Ferritkern 94. Der Ferritkern konzentriert die magnetischen Feldlinien 50, er sorgt jedoch im Gegensatz zu den gattungsgemäß verwendeten Ferrittöpfen nicht für eine einzelne Betriebs- oder Vorzugsrichtung. Es versteht sich, dass ein solcher Ferritkern auch in den vorherigen Ausführungsbeispielen Verwendung finden kann.

Die Spule 92 ist hier zusammen mit anderen Bauelementen 96 des Sensors auf einem Bauteilträger 98 angeordnet. Beispielhaft, jedoch nicht beschränkend, ist hier als anderes Bauelement ein IC dargestellt, bei dem es sich beispielsweise um einen ASIC handeln kann.

Die Betätigerantenne 56 ist in diesem Ausführungsbeispiel ebenfalls als flache (Luft-)Spule ausgebildet. Wie anhand der Fig. 5 und 6 dargestellt ist, kann die Betätigerantenne 56 aufgrund der ausladenden Feldlinienverteilung von mehreren Positionen aus mit der Sensorantenne 92 transformatorisch gekoppelt werden. Damit ist ein Anfahren des Sensor aus verschiedenen Richtungen möglich, ohne dass der Sensor oder die Sensorantenne ummontiert werden müssen. Andererseits ergibt sich durch die liegende Anordnung der Antennen eine sehr flache Bauform, die insbesondere bei der in Fig. 6 dargestellten Anfahrposition eine kleinbauende Montage ermöglicht.

Die vorliegende Erfindung wurde hier an Hand von bevorzugten Ausführungsbeispielen dargestellt, bei denen auf Seiten des Betätigers 16 ein an sich bekannter Transponder (Tag) zur Anwendung kommt. Dementsprechend muss die transformatorische Kopplung zwischen Betätiger 16 und Sensor 18, genauer zwischen der Betätigerantenne 56 und der Sensorantenne 46, stark genug sein, um den Transponder anzuregen. Dieser Zustand wird im Rahmen der vorliegenden Erfindung als transponderartige Kopplung bezeichnet. Abweichend von diesem bevorzugten Ausführungsbeispiel kann das Prinzip der Erfindung allerdings auch bei Sicherheitsschaltern angewendet werden, die nicht auf der Auswertung eines Transponders beruhen. Der allgemeine Anwendungsfall schließt daher auch transformatorische Kopplungen zwischen Betätiger 16 und Sensor 18 ein, die ohne Transponder auskommen.

## Patentansprüche

1. Sicherheitsschalter zum Überwachen einer Schließposition zweier relativ zueinander beweglicher Teile (12, 20), insbesondere zum Überwachen einer Schutztür an einer automatisierten Anlage (10), mit einem Betätiger (16) und mit einem Sensor (18), die an jeweils einem der Teile (12, 20) fixierbar sind, wobei der Betätiger (16) eine Betätigerantenne (56) und der Sensor (18) eine Sensorantenne (46; 92) besitzen, über die der Betätiger (16) und der Sensor (18) in der Schließposition der Teile (12, 20) transformatorisch, insbesondere transponderartig, gekoppelt sind, **dadurch gekennzeichnet, dass** die Sensorantenne (46; 92) eine magnetische Richtcharakteristik (62; 82) besitzt, die ausgehend von der Sensorantenne (46; 92) in zumindest zwei zueinander senkrechten Raumrichtungen (64, 66, 68) eine transformatorische Kopplung mit dem Betätiger (16) ermöglicht, wobei die Richtcharakteristik (62) eine stärkere erste (72) und eine schwächere zweite (74) Vorzugsrichtung für die transformatorische Kopplung aufweist und wobei die Sensorantenne (46) in einem Sensor gehäuse (38) mit Gehäusewänden (40, 42, 44) angeordnet ist, wobei ein Abstand (d₁) zwischen Sensorantenne (46) und Gehäusewand (40, 42, 44) in der ersten Vorzugsrichtung (72) größer ist als in der zweiten Vorzugsrichtung (74).

2. Sicherheitsschalter nach Anspruch 1, **dadurch gekennzeichnet, dass** die Sensorantenne (46; 92) eine im wesentlichen rundstrahlerartige Richtcharakteristik (62; 82) besitzt.

3. Sicherheitsschalter nach Anspruch 1 oder 2, **dadurch gekennzeichnet, dass** die Sensorantenne (46) eine Vielzahl von Teilantennen (86, 88) mit unterschiedlich ausgerichteten Richtcharakteristiken beinhaltet.

4. Sicherheitsschalter nach einem der Ansprüche 1 bis 3, **dadurch gekennzeichnet, dass** die Sensorantenne (46) eine Luftspule beinhaltet.

5. Sicherheitsschalter nach einem der Ansprüche 1 bis 4, **dadurch gekennzeichnet, dass** die Sensorantenne (92) eine Spule beinhaltet, die auf einem Bauteilträger (98) des Sensors (18) flach angeordnet ist, insbesondere als Leiterbahn auf dem Bauteilträger (98) ausgebildet ist.

6. Sicherheitsschalter nach einem der Ansprüche 1 bis 5, **dadurch gekennzeichnet, dass** die Sensorantenne (46) senkrecht zu der ersten Vorzugsrichtung (72) in gleichem Abstand (d₂) zu zumindest zwei Gehäusewänden (42, 44) angeordnet ist.

7. Sicherheitsschalter nach einem der Ansprüche 1 bis 6, **dadurch gekennzeichnet, dass** das Sensorgehäuse (38) eine Montageseite aufweist, wobei zwischen der Sensorantenne (46) und der Montageseite eine Feldisolierung (52), insbesondere eine elektrisch und/oder magnetisch leitfähige Platte, angeordnet ist.

8. Sicherheitsschalter nach einem der Ansprüche 1 bis 7, **dadurch gekennzeichnet, dass** das Sensorgehäuse (38) eine Montageseite aufweist, wobei ein Abstand (d₃) zwischen der Sensorantenne (46) und der Montageseite etwa 5 mm oder mehr beträgt.

9. Sicherheitsschalter nach einem der Ansprüche 1 bis 8, **dadurch gekennzeichnet, dass** die Betätigerantenne (56) bei der transformatorischen Kopplung in einer ersten (64) der zumindest zwei senkrechten Raumrichtungen eine erste Orientierung (16) und bei der transformatorischen Kopplung in einer zweiten (68) der zumindest zwei senkrechten Raumrichtungen eine zweite Orientierung (16") aufweist, wobei die erste und die zweite Orientierung um etwa 90° verdreht zueinander sind.

## Claims

1. A safety switch for monitoring a closed position of two parts (12, 20) which are moveable relative to one another, in particular for monitoring a guard door on an automated installation (10), comprising an actuator (16) and a sensor (18) each adapted to be secured to one of the parts (12, 20), with the actuator (16) having an actuator antenna (56) and the sensor (18) having a sensor antenna (46; 92), via which antennas the actuator (16) and the sensor (18) are transformer-coupled, in particular like a transponder, when the parts (12, 20) are in the closed position, **characterized in that** the sensor antenna (46; 92) has a magnetic directional characteristic (62; 82) which allows transformer coupling with the actuator (16) in at least two mutually perpendicular spatial directions (64, 66, 68) starting from the sensor antenna (46; 92), wherein the directional characteristic (62) comprises a stronger first preferential direction (72) and a weaker second preferential direction (74) for the transformer coupling, wherein the sensor antenna (46) is arranged in a sensor housing (38) having housing walls (40, 42, 44), and wherein a distance (d₁) between the sensor antenna (46) and the housing wall (40, 42, 44) in the first preferential direction (72) is longer than in the second preferential direction (74).

2. The safety switch of claim 1, **characterized in that** the sensor antenna (46; 92) has a substantially omnidirectional characteristic (62; 82).

3. The safety switch of claim 1 or 2, **characterized in that** the sensor antenna (46) comprises a plurality of antenna elements (86, 88) having differently aligned directional characteristics.

4. The safety switch of any one of claims 1 to 3, **characterized in that** the sensor antenna (46) comprises an air coil.

5. The safety switch of any one of claims 1 to 4, **characterized in that** the sensor antenna (92) comprises a coil which is flatly arranged on a circuit board (98) of the sensor (18), and in particular in the form of a conductor track on the circuit board (98).

6. The safety switch of any of claims 1 to 5, **characterized in that** the sensor antenna (46), perpendicular to the first preferential direction (72), is arranged at same distances (d₂) from at least two housing walls (42, 44).

7. The safety switch of any one of claims 1 to 6, **characterized by** the sensor housing (38) having a mounting face, wherein a field insulation (52), in particular an electrically and/or magnetically conductive plate, is arranged between the sensor antenna (46) and the mounting face.

8. The safety switch of any one of claims 1 to 7, **characterized by** the sensor housing (38) having a mounting face, wherein a distance (d₃) between the sensor antenna (46) and the mounting face is approximately 5 mm or more.

9. The safety switch of any one of claims 1 to 8, **characterized in that** the actuator antenna (56) has a first orientation (16) for the transformer coupling in a first (64) of the at least two perpendicular spatial directions, and the actuator antenna (56) has a second orientation (16") for the transformer coupling in a second (68) of the at least two perpendicular spatial directions, wherein the first and the second orientations are rotated by about 90° with respect to one another.

## Revendications

1. Interrupteur de sécurité servant à surveiller une position de fermeture de deux pièces mobiles l'une par rapport à l'autre (12, 20), en particulier à surveiller une porte de sécurité d'une installation automatisée (10), comprenant un dispositif d'actionnement (16) et un capteur (18), qui peuvent être fixés à chaque fois sur l'une des pièces (12, 20), le dispositif d'actionnement (16) possédant une antenne de dispositif d'actionnement (56) et le capteur (18) possédant une antenne de capteur (46; 92), par le biais desquelles le dispositif d'actionnement (16) et le capteur (18) sont accouplés dans la position de fermeture des pièces (12, 20) à la manière d'un transformateur, en particulier d'un transpondeur, **caractérisé en ce que** l'antenne de capteur (46; 92) possède une caractéristique d'orientation magnétique (62; 82) qui permet, à partir de l'antenne de capteur (46; 92), dans au moins deux directions spatiales (64, 66, 68) perpendiculaires l'une à l'autre, un accouplement de type transformateur avec le dispositif d'actionnement (16), la caractéristique d'orientation (62) présentant une première orientation préférentielle plus forte (72) et une deuxième orientation préférentielle plus faible (74) pour l'accouplement de type transformateur, et l'antenne de capteur (46) étant disposée dans un boîtier de capteur (38) avec des parois de boîtier (40, 42, 44), une distance (d₁) entre l'antenne de capteur (46) et la paroi de boîtier (40, 42, 44) dans la première orientation préférentielle (72) étant plus grande que dans la deuxième orientation préférentielle (74).

2. Interrupteur de sécurité selon la revendication 1, **caractérisé en ce que** l'antenne de capteur (46; 92) possède une caractéristique d'orientation sensiblement omnidirectionnelle (62; 82).

3. Interrupteur de sécurité selon la revendication 1 ou 2, **caractérisé en ce que** l'antenne de capteur (46) contient une pluralité d'antennes partielles (86, 88) ayant des caractéristiques d'orientation orientées différemment.

4. Interrupteur de sécurité selon l'une quelconque des revendications 1 à 3, **caractérisé en ce que** l'antenne de capteur (46) contient une bobine sans fer.

5. Interrupteur de sécurité selon l'une quelconque des revendications 1 à 4, **caractérisé en ce que** l'antenne de capteur (92) contient une bobine qui est disposée à plat sur un support de composant (98) du capteur (18), en particulier qui est réalisée sous forme de piste conductrice sur le support de composant (98).

6. Interrupteur de sécurité selon l'une quelconque des revendications 1 à 5, **caractérisé en ce que** l'antenne de capteur (46) est disposée perpendiculairement à la première orientation préférentielle (72) à la même distance (d₂) d'au moins deux parois de boîtier (42, 44).

7. Interrupteur de sécurité selon l'une quelconque des revendications 1 à 6, **caractérisé en ce que** le boîtier de capteur (38) présente un côté de montage, une isolation de champ (52), en particulier une plaque électriquement et/ou magnétiquement conductrice, étant disposée entre l'antenne de capteur (46) et le côté de montage.

8. Interrupteur de sécurité selon l'une quelconque des revendications 1 à 7, **caractérisé en ce que** le boîtier de capteur (38) présente un côté de montage, une distance (d₃) entre l'antenne de capteur (46) et le côté de montage étant d'environ 5 mm ou plus.

9. Interrupteur de sécurité selon l'une quelconque des revendications 1 à 8, **caractérisé en ce que** l'antenne de dispositif d'actionnement (56) présente, dans l'accouplement de type transformateur, dans une première (64) des au moins deux orientations spatiales perpendiculaires, une première orientation (16), et dans l'accouplement de type transformateur, dans une deuxième (68) des au moins deux orientations spatiales perpendiculaires, une deuxième orientation (16"), la première et la deuxième orientation étant tournées d'environ 90° l'une par rapport à l'autre.
